Europäisches Patentamt

European Patent Office

Office européen des brevets

(11) Veröffentlichungsnummer: **0 469 375 A2**

# EUROPÄISCHE PATENTANMELDUNG

(21) Anmeldenummer: **91111811.5**

(51) Int. Cl.5: **G03F 7/18**

(22) Anmeldetag: **16.07.91**

(30) Priorität: **30.07.90 DE 4024151**

(43) Veröffentlichungstag der Anmeldung:
**05.02.92 Patentblatt 92/06**

(84) Benannte Vertragsstaaten:
**BE CH DE FR GB IT LI NL SE**

(71) Anmelder: **BASF Aktiengesellschaft
Carl-Bosch-Strasse 38
W-6700 Ludwigshafen(DE)**

(72) Erfinder: **Telser, Thomas, Dr.
Langer Wiesenweg 13
W-6940 Weinheim(DE)**

(54) **Verfahren zur Herstellung von Druckzylindern mit nahtloser photolymerer Reliefschicht für den Rotationsdruck.**

(57) Bei einem neuen Verfahren zur Herstellung von Druckzylindern mit nahtloser photopolymerer Reliefschicht für den Rotationsdruck, bei welchem man ein lichtempfindliches Aufzeichnungselement mit einer photopolymerisierbaren Aufzeichnungsschicht nahtlos auf der Oberfläche eines Druckzylinders aufbringt, hiernach die Oberfläche der photopolymerisierbaren Aufzeichnungsschicht schleift, danach die geschliffene Oberfläche durch eine Behandlung mit einem organischen Lösungsmittel oder Lösungsmittelgemisch, worin die photopolymerisierbare Aufzeichnungsschicht löslich oder dispergierbar ist, und/oder durch das Auffüllen des Schleifreliefs mit einem thermoplastischen Bindemittel und/oder durch eine Wärme- und/oder Druckbehandlung glättet, die photopolymerisierbare Aufzeichnungsschicht mit aktinischem Licht bildmäßig belichtet und hiernach die unbelichteten und daher nicht photopolymerisierten Bereiche der bildmäßig belichteten Aufzeichnungsschicht unter Bildung der nahtlosen photopolymeren Reliefschicht mit einem geeigneten Lösungsmittel oder Lösungsmittelgemisch entwickelt, wird für die Behandlung der geschliffenen Oberfläche mit einem geeigneten organischen Lösungsmittel oder Lösungsmittelgemisch und/oder für das Auffüllen des Schleifreliefs und/oder für das Entwickeln der bildmäßig belichteten Aufzeichnungsschicht eine Emulsion vom Typ "Wasser-in-Öl" verwendet, welche eine fein dispergierte wäßrige Phase und eine kontinuierliche nichtbrennbare oder schwerbrennbare und/oder hochsiedende organische Phase im Volumenverhältnis von 90:10 bis 10:90 enthält.

EP 0 469 375 A2

Die vorliegende Erfindung richtet sich auf ein neues, verbessertes Verfahren zur Herstellung von Druckzylindern mit nahtloser photopolymerer Reliefschicht für den Rotationsdruck, bei welchem man ein lichtempfindliches Aufzeichnungselement mit einer photopolymerisierbaren Aufzeichnungsschicht nahtlos auf der Oberfläche eines Druckzylinders aufbringt, hiernach die Oberfläche der photopolymerisierbaren Aufzeichnungsschicht schleift, im Anschluß daran die geschliffene Oberfläche durch eine Behandlung mit einem organischen Lösungsmittel oder Lösungsmittelgemisch, worin die photopolymerisierbare Aufzeichnungsschicht löslich oder dispergierbar ist, und/oder durch das Auffüllen des Schleifreliefs mit einem thermoplastischen Bindemittel und/oder durch eine Wärme- und/oder Druckbehandlung glättet, im Anschluß daran die photopolymerisierbare Aufzeichnungsschicht mit aktinischem Licht bildmäßig belichtet und dann die bildmäßig belichtete Aufzeichnungsschicht mit einem geeigneten Lösungsmittel oder Lösungsmittelgemisch unter Bildung der nahtlosen photopolymeren Reliefschicht entwickelt.

Dieses Verfahren ist, sieht man von der erfindungsgemäßen Verbesserung ab, aus der DE-B-31 25 564 bekannt. Bei diesem bekannten Verfahren werden beispielsweise Flexodruckplatten, welche man gemäß der DE-C-22 15 090 hergestellt hat, nahtlos auf Druckzylinder montiert, wobei man hierzu das Verfahren der DE-A-27 22 896 verwenden kann, und nach der Montage zur Erzielung der erforderlichen Rundlaufgenauigkeit auf eine Toleranzdicke ± 0,01 mm geschliffen. Wie aus der DE-B-31 25 564 weiter hervorgeht, wird durch diesen Schleifprozeß die Druckqualität ganz erheblich beeinträchtigt. Insbesondere erhält man nach der Entwicklung ein unzureichend ausgebildetes Relief mit ungenügenden Tiefen, was zu einer schlechten Wiedergabequalität bei feinen Bildelementen führt. Die geringe Relieftiefe beeinträchtigt ferner die Auflagenbeständigkeit, eine Wirkung, welche durch den erhöhten Abrieb, verursacht durch die rauhe geschliffene Oberfläche, noch verstärkt wird.

Um dieses Problem zu lösen, wird in der DE-B-31 25 564 empfohlen, die geschliffene Oberfläche durch Behandeln mit einem organischen Lösungsmittel oder Lösungsmittelgemisch, worin die photopolymerisierbare Aufzeichnungsschicht löslich oder dispergierbar ist, zu glätten. Außerdem kann das Glätten der geschliffenen Oberfläche auch durch Ausfüllen des Schleifreliefs mit einem thermoplastischen Bindemittel erfolgen. Zu diesem Zweck wird das thermoplastische Bindemittel in einem geeigneten Lösungsmittel gelöst und auf die geschliffene Oberfläche der photopolymerisierbaren Aufzeichnungsschicht derart aufgetragen, daß das durch den Schleifprozeß verursachte Relief gerade ausgeglichen wird. Hierbei wird die Verwendung von thermoplastischen Bindemitteln empfohlen, welche in wäßrigen oder wäßrigalkalischen Lösungen löslich sind. Ferner kann das Glätten noch durch eine an sich bekannte Wärme- und Druckbehandlung erfolgen.

Werden indes solche in wäßrigen oder wäßrig alkalischen Lösungen lösliche thermoplastische Bindemittel auf photopolymerisierbare Aufzeichnungsschichten aufgetragen, welche in organischen Lösungsmitteln oder Lösungsmittelgemischen löslich oder dispergierbar sind, ergeben sich Probleme bei der nachfolgenden Entwicklung der betreffenden bildmäßig belichteten Aufzeichnungsschichten, weil die für die Entwicklung geeigneten organischen Lösungsmittel oder Lösungsmittelgemische nicht das zu Glättungszwecken aufgetragene thermoplastische Bindemittel wegzulösen vermögen. In diesen Fällen ist es deshalb notwendig, das aufgetragene, in wäßrigen oder wäßrig-alkalischen Lösungen lösliche thermoplastische Bindemittel in einem sogenannten "prewipe"-Schritt wegzuwaschen. Dies bedeutet, daß bei der Herstellung von Druckzylindern mit nahtlosen photopolymeren Reliefschichten ein zusätzlicher Verfahrensschritt notwendig wird, was in der betrieblichen Praxis des reprographischen Betriebs ein schwerwiegender Nachteil ist.

Der wesentliche Nachteil des aus der DE-B-31 25 564 bekannten Verfahrens liegt indes zum einen darin, daß es nicht bei nahtlos aufgebrachten lichtempfindlichen Aufzeichnungselementen angewandt werden kann, welche eine in Wasser oder wäßrig-alkalischen Lösungsmitteln lösliche oder dispergierbare photopolymerisierbare Aufzeichnungsschicht enthalten, und andererseits darin, daß die bei dem bekannten Verfahren angewandten organischen Lösungsmittel oder Lösungsmittelgemische beim Glätten die Oberfläche der photopolymerisierbaren Aufzeichnungsschicht und beim Entwickeln die bildmäßig belichtete Aufzeichnungsschicht so stark angreifen, daß der Verfahrenserfolg, welcher durch das Glätten eigentlich erzielt werden soll, sich erst gar nicht einstellt bzw. wieder zunichte gemacht wird. Diese Nachteile lassen sich allerdings nur zum Teil dadurch umgehen, daß man sich beim Glätten auf die an sich bekannte Wärme- und/oder Druckbehandlung beschränkt. Diese Beschränkung ist indes als weiterer Nachteil anzusehen.

Des weiteren ist aus der US-A-4 847 182 ein Verfahren bekannt, bei welchem man Gemische aus Terpenen und sogenannten "Nicht-Lösungsmittel" wie n-Butanol, 2-Ethoxyethanol, Benzylalkohol, Ethanol, 2-Butoxyethanol, Isopropylalkohol, 2-(2-Butoxyethoxy)-ethanol, Mineralöl, "mineral spirits", Ligroin, Dekan oder Octan in Form wäßriger Emulsionen für die Entwicklung bildmäßig belichteter Aufzeichnungsschichten von lichtempfindlichen Aufzeichnungselementen verwendet. Die Verwendung dieser Emulsionen für das eingangs genannte Verfahren zur Herstellung von Druckzylindern mit nahtloser photopolymerer Reliefschicht für den Rotationsdruck wird in der US-A-4 847 182 nicht angesprochen.

Ansonsten werden in den beiden nicht vorveröffentlichten älteren deutschen Patentanmeldungen P 3908764.6 und P 3908763.8 Verfahren beschrieben, bei welchen Emulsionen aus organischen Lösungsmitteln und Wasser für das Entwickeln bildmäßig belichteter Aufzeichnungselemente (Flexodruckplatten) verwendet werden. Hierbei kommen als organische Lösungsmittel chlorierte Kohlenwasserstoffe, gesättigte und/oder ungesättigte cyclische Kohlenwasserstoffe, gesättigte und/oder ungesättigte acyclische Kohlenwasserstoffe, Petroleumdestillate, hydrierte Erdölfraktionen und/oder deren Gemische in Betracht, sofern sie jeweils für sich selbst gesehen, bereits nichtbrennbar, schwerbrennbar und/oder hochsiedend sind. Außerdem kommen Gemische langkettiger Alkylester mit Alkylgruppen unterschiedlicher Kettenlänge, welche indes nicht näher spezifiziert werden, in Betracht. Diese Emulsionen können außerdem noch 0,1 bis 20 Vol.-% mindestens eines Alkohols wie etwa n-Butanol, n-Pentanol, n-Hexanol, Cyclohexanol, n-Heptanol, n-Octanol, n-Dekanol, Laurylalkohol, 3-Methyl-3-methoxybutanol, Benzylalkohol oder 2,3,5-Trimethylhexanol enthalten.

Aufgabe der vorliegenden Erfindung ist es, das eingangs genannte Verfahren weiter zu entwickeln, um so zu einem neuen, verbesserten Verfahren zur Herstellung von Druckzylindern mit nahtloser photopolymerer Reliefschicht für den Rotationsdruck zu gelangen, welches insbesondere die vorstehend genannten Nachteile des Standes der Technik nicht mehr länger aufweist.

Zur Lösung dieser Aufgabe hat überraschenderweise die Verwendung von Emulsionen vom Typ "Wasser-in-Öl" beigetragen, welche sowohl für die Glättung der geschliffenen Oberfläche der photopolymerisierbaren Aufzeichnungsschichten als auch für die Entwicklung der bildmäßig belichteten Aufzeichnungsschichten verwendet werden können. Im Hinblick auf den Stand der Technik war erst recht nicht zu erwarten, daß mit Hilfe der Wasser-in-Öl-Emulsionen nicht nur die vorstehend beschriebenen Nachteile des Standes der Technik vermieden, sondern darüber hinaus auch noch besondere unerwartete Vorteile erzielt werden. Insbesondere war der Befund überraschend, daß die Wasser-in-Öl-Emulsionen keinerlei Quellschäden an den photopolymerisierbaren Aufzeichnungsschichten und an den photopolymeren Reliefschichten hervorrufen, zu kürzen Trocknungszeiten führen und keinen Langzeitschrumpf der photopolymeren Reliefschichten auf den Druckzylinder verursachen. Hinzu kommt noch, daß diese Wasser-in-Öl-Emulsionen keine Geruchsbelästigungen des Bedienungspersonals mehr hervorrufen und sicherheitstechnisch unbedenklich sind.

Bei dem Gegenstand der vorliegenden Erfindung handelt es sich demnach um ein neues Verfahren zur Herstellung von Druckzylindern mit nahtloser photopolymerer Reliefschicht für den Rotationsdruck durch

A) nahtloses Aufbringen eines lichtempfindlichen Aufzeichnungselements mit einer photopolymerisierbaren Aufzeichnungsschicht auf der Oberfläche eines Druckzylinders,

B) Schleifen der Oberfläche der photopolymerisierbaren Aufzeichnungsschicht,

C) Glätten der geschliffenen Oberfläche durch

$C_1$) eine Behandlung der geschliffenen Oberfläche mit einem organischen Lösungsmittel oder Lösungsmittelgemisch, worin die photopolymerisierbare Aufzeichnungsschicht löslich oder dispergierbar ist, und/oder

$C_2$) das Ausfüllen des Schleifreliefs mit einem thermoplastischen Bindemittel und/oder

$C_3$) eine Wärme- und/oder Druckbehandlung,

D) bildmäßiges Belichten der photopolymerisierbaren Aufzeichnungsschicht mit aktinischem Licht und

E) Auswaschen (Entwickeln) der unbelichteten und daher nicht photopolymerisierten Bereiche der bildmäßig belichteten Aufzeichnungsschicht mit einem geeigneten Lösungsmittel oder Lösungsmittelgemisch, wodurch die nahtlose photopolymere Reliefschicht resultiert,

wobei das neue, verbesserte Verfahren dadurch gekennzeichnet ist, daß man bei den Verfahrensschritten $(C_1)$, $(C_2)$ und/oder (E) eine Emulsion vom Typ "Wasser-in-Öl" verwendet, welche eine fein dispergierte wäßrige Phase und eine kontinuierliche nichtbrennbare oder schwerbrennbare und/oder hochsiedende organische Phase im Volumenverhältnis von 90:10 bis 10:90 enthält.

Im folgenden wird das neue, verbesserte Verfahren zur Herstellung von Druckzylindern mit nahtloser photopolymerer Reliefschicht für den Rotationsdruck der Kürze halber als "erfindungsgemäßes Verfahren" bezeichnet.

Das erfindungsgemäß wesentliche Merkmal des erfindungsgemäßen Verfahrens ist die Verwendung von Wasser-in-Öl-Emulsionen, welche für den hier in Rede stehenden Zweck bislang noch nicht angewandt worden sind.

Die erfindungsgemäß zu verwendende Wasser-in-Öl-Emulsion enthält eine fein dispergierte wäßrige Phase und eine kontinuierliche organische Phase. Erfindungsgemäß ist es hier von Vorteil, wenn das Volumenverhältnis der wäßrigen Phase zur organischen Phase bei 90:10 bis 10:90 liegt. Es ist durchaus möglich, dieses Volumenverhältnis größer, beispielsweise 95:5, oder kleiner, beispielsweise 5:95, zu wählen. Indes kommen Wasser-in-Öl-Emulsionen, welche solche Volumenverhältnisse aufweisen, entweder nur für ganz spezielle Verwendungszwecke in Betracht, oder die besonderen Vorteile des erfindungsgemäßen Verfahrens stellen sich nicht immer in zuverlässiger Weise ein. Demnach handelt es sich bei dem Volumenverhältnis von 90:10 bis 10:90 um den optimalen Bereich für die Volumenverhältnisse der Wasser-in-Öl-Emulsion, innerhalb dessen das Volumenverhältnis von wäßriger Phase zu organischer Phase in vorteilhafter Weise gezielt eingestellt und dem betreffenden Verwendungszweck angepaßt werden kann.

Innerhalb dieses optimalen Bereichs ist derjenige von 70:30 bis 30:70 besonders vorteilhaft, weil die erfindungsgemäß zu verwendenden Wasser-in-Öl-Emulsionen, welche ein Volumenverhältnis in diesem Bereich aufweisen, eine besonders gute und dennoch schonende Wirkung bei der Glättung und der Entwicklung entfalten.

Ganz besonders bevorzugt werden die Wasser-in-Öl-Emulsionen verwendet, welche ein Volumenverhältnis im Bereich von 60:40 bis 40:60 aufweisen. Die Verwendung dieser Wasser-in-Öl-Emulsionen bei dem erfindungsgemäßen Verfahren haben ein besonders vorteilhaftes Eigenschaftsprofil der hiermit hergestellten Druckzylinder mit nahtloser photopolymerer Reliefschicht zur Folge.

Der eine wesentliche Bestandteil der erfindungsgemäß zu verwendenden Wasser-in-Öl-Emulsion ist die fein dispergierte wäßrige Phase, welche destilliertes oder entsalztes Wasser oder normales Leitungswasser mit Trinkwasserqualität enthält. Vorzugsweise handelt es sich um normales Leitungswasser.

Hierbei kann die wäßrige Phase noch geeignete Zusatzstoffe gelöst enthalten.

Beispiele geeigneter Zusatzstoffe sind wasserlösliche organische und anorganische Säuren oder Basen, organische und anorganische saure und basische Salze, Komplexbildner und geruchsverbessernde Stoffe.

Diese Zusatzstoffe werden in solchen Mengen verwendet, daß sie die Bildung und die Stabilität der erfindungsgemäßen Wasser-in-Öl-Emulsion nicht beeinträchtigten.

Der andere wesentliche Bestandteil der erfindungsgemäß zu verwendenden Wasser-in-Öl-Emulsion ist die kontinuierliche organische Phase, welche als solche nichtbrennbar oder schwerbrennbar und/oder hochsiedend ist. Hierbei bedeutet "nichtbrennbar", daß die betreffende organische Phase für sich selbst gesehen unter dem Sauerstoffpartialdruck der Luft die Verbrennung nicht aufrechterhält. "Schwerbrennbar" bedeutet, daß die organische Phase für sich selbst gesehen einen Flammpunkt nach DIN 51 755 oder DIN 51 758 oberhalb 45, vorzugsweise 50 und insbesondere 60 ˚C hat. "Hochsiedend" bedeutet, daß die betreffende organische Phase einen Siedepunkt oder Siedebereich oberhalb 120, vorzugsweise 150 und insbesondere 160 ˚C hat.

Geeignete organische Phasen bestehen in der Hauptsache aus chlorierten Kohlenwasserstoffen, aromatischen Kohlenwasserstoffen, Estern, Ethern und/oder Ketonen, gesättigten und/oder ungesättigten cyclischen Kohlenwasserstoffen, Estern, Ethern und/oder Ketonen, gesättigten und/oder ungesättigten acyclischen Kohlenwasserstoffen, Estern, Ethern und/oder Ketonen, Petroleumdestillaten, hydrierten Erdölfraktionen und/oder deren Gemischen, welche allesamt für sich selbst gesehen bereits nichtbrennbar oder schwerbrennbar und/oder hochsiedend sind.

Beispiele gut geeigneter organischer Phasen sind organische Lösungsmittel oder Lösungsmittelgemische, welche bereits zu Zwecken der Entwicklung nicht photopolymerisierter Bereiche bildmäßig belichteter Aufzeichnungsschichten verwendet worden sind. Beispiele besonders gut geeigneter organischer Phasen bzw. organischer Lösungsmittel oder Lösungsmittelgemische gehen aus den Patentschriften EP-A-0 228 676 (US-A-4 806 452), EP-A-0 332 070, US-A-4 847 182, EP-A-0 355 789, DE-A-38 36 402, DE-A-38 36 403 oder DE-A-38 36 404 hervor.

Außerdem kann die erfindungsgemäß zu verwendende Wasser-in-Öl-Emulsion, bezogen auf ihre Gesamtmenge, 0,1 bis 30 Vol.-% mindestens eines Alkohols und/oder 0,001 bis 20 Vol.-% mindestens einer oberflächenaktiven Verbindung enthalten.

Außerdem kann die erfindungsgemäß zu verwendende Wasser-in-Öl-Emulsion geeignete geruchsverbessernde Stoffe in einer solchen Menge gelöst enthalten, daß die Bildung und die Stabilität der Emulsion nicht beeinträchtigt werden.

Die erfindungsgemäß zu verwendenden Wasser-in-Öl-Emulsionen sind an sich bekannte Stoffe und sind beispielsweise aus den Patentschriften US-A-4 446 044, US-A-3 929 499, JP-A-54/063108 (Derwent-Kurzreferat Nr. 48178 B/26), US-A-4 438 009, US-A-4 163 673, US-A-4 704 225, JP-A-59/033396 (Derwent-Kurzreferat Nr. 84-084544) und JP-A-53/102280 (Chem. Abstr., Band 90, 1979, Kurzreferat Nr. 8005 j) bekannt.

Methodisch bietet die Herstellung der Wasser-in-Öl-Emulsionen zur Verwendung in dem erfindungsgemäßen Verfahren keine Besonderheiten, sondern erfolgt in üblicher und bekannter Weise durch das Zusammengeben der gewünschten Bestandteile in den gewünschten Mengen unter intensiver Durchmischung durch Rühren, Versprühen und Umpumpen. Hierbei ist es von Vorteil, die betreffenden Bestandteile zusammen in einem Vorratsbehälter aufzubewahren und hieraus die erfindungsgemäß zu verwendende

EP 0 469 375 A2

Wasser-in-Öl-Emulsion unmittelbar vor ihrer Verwendung herzustellen.

Die Verwendung der vorstehend im Detail beschriebenen Wasser-in-Öl-Emulsionen bei dem erfindungsgemäßen Verfahren hat besondere unerwartete Vorteile zur Folge. So sind die erfindungsgemäß zu verwendenden Wasser-in-Öl-Emulsionen weitgehend oder völlig geruchlos oder sie weisen einen im Vergleich zu der reinen organischen Phase deutlich geringeren oder erheblich angenehmeren Geruch auf. Sofern keine nichtbrennbare organische Phase wie beispielsweise Tetrachlorethylen verwendet wird, ist ihr Flammpunkt im Vergleich zur reinen, ohnedies schon schwerbrennbaren organischen Phase deutlich erhöht, weswegen für die Anwendung der Wasser-in-Öl-Emulsionen bei dem erfindungsgemäßen Verfahren keine explosionsgeschützten Anlagen notwendig sind. Für den Fall, daß eine vergleichsweise stark toxische organische Phase in der erfindungsgemäß zu verwendenden Wasser-in-Öl-Emulsion enthalten ist, kann die Emission der betreffenden organischen Phase durch einen erheblich geringeren technischen Aufwand unterdrückt werden, als dies bei der Verwendung der reinen organischen Phase der Fall ist, so daß die von den Gesetzgebern vorgeschriebenen Maximalwerte für die Emission der betreffenden reinen organischen Phase signifikant unterschritten werden, weswegen die Verwendung der betreffenden Wasser-in-Öl-Emulsionen auch aus sicherheitstechnischen, ökologischen und gesundheitlichen Gründen von Vorteil ist. Deshalb können auch die betreffenden erfindungsgemäß zu verwendenden Wasser-in-Öl-Emulsionen bei deutlich höheren Temperaturen verwendet werden, was ihre ohnehin schon vorzügliche Lösungskraft noch weiter steigert. Darüber hnaus kann die bei dem erfindungsgemäßen Verfahren verbrauchte Wasser-in-Öl-Emulsion, selbst wenn sie eine besonders hochsiedende organische Phase enthält, in einfacher Weise durch Destillation oder Wasserdampfdestillation bei Normaldruck gereinigt und im Anschluß daran wieder verwendet werden.

Methodisch gesehen bietet auch das erfindungsgemäße Verfahren keine Besonderheiten, d.h. man montiert in üblicher und bekannter Weise ein lichtempfindliches Aufzeichnungselement mit einer photopolymerisierbaren Aufzeichnungsschicht nahtlos auf der Oberfläche eines Druckzylinders. Verfahren zum nahtlosen Montieren von lichtempfindlichen Aufzeichnungselementen mit einer photopolymerisierbaren Aufzeichnungsschicht sind beispielsweise aus den Patentschriften DE-A-27 22 896, DE-A-29 11 908, DE-A-28 42 440, DE-A-37 04 694, DE-A-37 04 693 und DE-A-37 04 695 bekannt. Die durch die Montage verursachten Dickenunterschiede innerhalb der photopolymerisierbaren Aufzeichnungsschicht des montierten lichtempfindlichen Aufzeichnungselements werden dann in üblicher und bekannter Weise mit Hilfe eines Präzisions-Schleifprozesses beseitigt, wodurch die Dickentoleranz von etwa ± 10 μm wieder eingestellt wird, welche für die Rundlaufgenauigkeit des fertigen Druckzylinders erforderlich ist.

Die durch den Präzisions-Schleifprozeß hervorgerufene Oberflächenrauheit muß indes wieder geglättet werden.

Sofern die erfindungsgemäß zu verwendenden Wasser-in-Öl-Emulsionen für das Entwickeln der bildmäßig belichteten nahtlosen Aufzeichnungsschicht des Druckzylinders verwendet werden, kommen für das Glätten die aus der DE-B-31 25 564 bekannten Verfahren in Betracht. Es ist indes erfindungsgemäß von Vorteil, auch für das Glätten Wasser-in-Öl-Emulsionen zu verwenden.

In erfindungsgemäßer Verfahrensweise wird hierzu die geschliffene Oberfläche der photopolymerisierbaren Aufzeichnungsschicht des nahtlos montierten lichtempfindlichen Aufzeichnungselements mit der vorstehend beschriebenen Wasser-in-Öl-Emulsion behandelt. Hierbei kann man die Wasser-in-Öl-Emulsion manuell mit einem Baumwolltupfer, Schwamm oder Pinsel oder durch Eintauchen der geschliffenen Oberfläche in ein Bad aufbringen. Die Wasser-in-Öl-Emulsion kann natürlich auch maschinell durch Besprühen oder Anspülen aufgebracht werden.

Erfindungsgemäß ist es von Vorteil, den Druckzylinder mit dem nahtlos montierten und in seiner Oberfläche geschliffenen lichtempfindlichen Aufzeichnungselement derart in ein Bad einzutauchen, daß nur die Oberfläche der photopolymerisierbaren Aufzeichnungsschicht mit der Wasser-in-Öl-Emulsion in Berührung kommt, und dabei den Druckzylinder langsam zu drehen.

Nach einer weiteren Ausführungsform kann das Glätten der geschliffenen Oberfläche auch durch Ausfüllen des Schleifreliefs mit einem thermoplastischen Bindemittel erfolgen.

Zu diesem Zweck wird das thermoplastische Bindemittel in erfindungsgemäßer Verfahrensweise in der Wasser-in-Öl-Dispersion gelöst. Hierbei zeigt sich ein weiterer Vorteil des erfindungsgemäßen Verfahrens, kann doch in der erfindungsgemäß zu verwendenden Wasser-in-Öl-Emulsion nicht nur ein in Wasser oder wäßrig alkalischen Lösungen lösliches Bindemittel, sondern auch ein in organischen Lösungsmitteln lösliches Bindemittel gelöst und hiernach auf der geschliffenen Oberfläche aufgetragen werden. Deswegen kann auch das erfindungsgemäße Verfahren erheblich breiter variiert und sehr viel besser speziellen Anwendungszwecken angepaßt werden, als dies bei den bekannten Verfahren der Fall ist.

Beispiele gut geeigneter thermoplastischer Bindemittel, welche in wäßrigen oder wäßrig alkalischen Lösungen löslich sind, sind Polyvinylalkohol, Polyvinylpyrrolidon, Polyacrylsäure, Polymethacrylsäure sowie

5

deren Copolymerisate mit Acrylsäure- und Methacrylsäureestern oder -amiden, partiell oder vollständig verseifte Maleinsäureanhydrid enthaltende Copolymerisate, Carboxylgruppen enthaltende Copolymere von Styrol, Butadien, Isopren oder Acrylnitril oder natürliche Polymere wie Alginsäure, Pektinsäure, Chelatine, Albumin oder Casein.

Beispiele geeigneter thermoplastischer Lösungsmittel welche in organischen Lösungsmitteln löslich sind sind Polyamide, Polyvinylacetat, Polyvinylpropionat, Polyalkylmethacrylate wie Polymethylmethacrylat, Polystyrol, Polybutadien, Polyisopren und Polycarbonat.

Das Aufbringen des thermoplastischen Bindemittels kann manuell durch Aufstreichen, Behandeln mit Tampons oder Schwämmen, die mit der betreffenden Wasser-in-Öl-Emulsion getränkt sind, oder durch Aufrakeln der Wasser-in-Öl-Emulsion erfolgen.

Unabhängig davon, welche der beiden erfindungsgemäßen Verfahrensvarianten man wählt, sind die Trocknungszeiten nach dem Glätten kürzer als bei dem herkömmlichen Verfahren.

Nach dem Glätten werden die photopolymerisierbaren Aufzeichnungsschichten der nahtlos montierten lichtempfindlichen Aufzeichnungselemente in üblicher und bekannter Weise mit aktinischem Licht einer Wellenlänge λ von 230 bis 450, insbesondere 300 bis 450 nm, bildmäßig belichtet. Hierfür geeignete Lichtquellen sind z.B. die Strahlung der Sonne, handelsübliche UV-Fluoreszenzröhren, Quecksilbermittel-, -hoch- und -niederdruckstrahler, superaktinische Leuchtstoffröhren, Xenonimpulslampen, mit Metalliodiden dotierte Lampen oder Kohlebogenlampen. Vorteilhafterweise wird die Belichtung mit aktinischem Licht in einem Rundbelichter durchgeführt.

Dem Belichtungsschritt schließt sich im weiteren Verlauf des erfindungsgemäßen Verfahrens das Auswaschen (Entwickeln) der unbelichteten und daher nicht photopolymerisierten Bereiche der bildmäßig belichteten Aufzeichnungsschicht unter Bildung der nahtlosen photopolymeren Reliefschicht an.

Sofern beim Glätten bereits in erfindungsgemäßer Verfahrensweise Wasser-in-Öl-Emulsionen angewandt worden sind, kann das Entwickeln in üblicher und bekannter Weise durchgeführt werden. Erfindungsgemäß ist es indes von ganz besonderem Vorteil, wenn auch für das Entwickeln die vorstehend im Detail beschriebene Wasser-in-Öl-Emulsion verwendet wird. Hierbei wird das Entwickeln in üblicher und bekannter Weise in den bekannten Sprüh-, Bürsten- und Reibewaschern bei Temperaturen von 20 bis 50°C durchgeführt. Dabei zeigt es sich, daß die für eine bestimmte Auswaschtiefe notwendige Auswaschzeit bei der Verwendung der erfindungsgemäß zu verwendenden Wasser-in-Öl-Emulsion trotz ihres hohen Wassergehalts entweder gar nicht oder nur unwesentlich höher ist als im Falle der Verwendung der reinen organischen Phase, daß aber die Lösungsmittelaufnahme der zurückbleibenden photopolymeren Reliefschicht in vielen Fällen verringert wird. Dadurch verbessert sich nicht nur die Überwaschresistenz der photopolymeren Reliefschichten ganz erheblich, d.h. auch wenn die für eine bestimmte Relieftiefe notwendige Auswaschzeit überschritten wird, werden fehlerfreie Reliefstrukturen erhalten, sondern die in erfindungsgemäßer Verfahrensweise hergestellten photopolymeren Reliefschichten zeigen bei längerer Lagerung oder bei Dauergebrauch nicht mehr den Langzeitschrumpf. Dieser Langzeitschrumpf kann, wenn er ausgeprägt ist, zur völligen Unbrauchbarkeit der betreffenden Druckzylinder mit nahtloser photopolymerer Reliefschicht führen. Die Erhöhung der Überwaschresistenz und die Vermeidung des Langzeitschrumpfes sind Vorteile, welche vor allem für Druckzylinder, die dem hochqualitativen Rasterflexodruck dienen, von Bedeutung sind.

Auch die Ausbruchstabilität der Reliefstrukturen wird durch die Verwendung der Wasser-in-Öl-Emulsionen erheblich verbessert. Dies ist von ganz besonderer Bedeutung bei Druckzylindern mit dicken weichelastischen flexographischen Reliefschichten mit tiefem Relief, wie sie beispielsweise im Kartonagen- und Wellpappendruck eingesetzt werden.

Ein weiterer überraschender Vorteil des erfindungsgemäßen Verfahrens, welcher sich aus der Verwendung der Wasser-in-Öl-Emulsionen ergibt, betrifft die druckende Oberfläche der Druckzylinder. Diese druckende Oberfläche ist von einwandfreier Beschaffenheit und weist keine unerwünschten Oberflächenstrukturen in der Form von Runzeln oder Würmchen, d.h. die sogenannte Orangenhaut auf, sondern sie ist gleichmäßig glatt oder mattiert. Außerdem bleiben keine Rückstände an photopolymerisierbarem Material in der Form von sogenannten Tropfnasen auf der druckenden Oberfläche zurück, was im Hinblick auf die Qualität der Druckerzeugnisse, welche mit den betreffenden Druckzylindern hergestellt werden, ein nicht zu unterschätzender Vorteil ist.

Ein weiterer überraschender Vorteil ist die Tatsache, daß sich aus der Verwendung der Wasser-in-Öl-Emulsionen als Entwicklerlösungsmittel keine verlängerten Trocknungszeiten nach der Entwicklung ergeben.

Vorteilhaft ist ferner, daß sowohl die Glättung als auch das Entwickeln mit Hilfe der Wasser-in-Öl-Emulsion in nicht exposionsgeschützten Geräten durchgeführt werden kann. Außerdem kann die Absaugung der betreffenden Geräte wegen des geringen Eigengeruchs und/oder der deutlich verringerten Toxizität der Wasser-in-Öl-Emulsionen stark reduziert werden.

Die in erfindungsgemäßer Verfahrensweise erhaltenen Druckzylinder mit nahtloser photopolymerer Reliefschicht für den Rotationsdruck können noch in Halogen enthaltenden oder liefernden Bädern halogeniert, in reduzierenden Bädern nachgewaschen und erneut getrocknet werden. Alternativ oder im Nachgang zu dieser Behandlung können die Druckzylinder noch mit aktinischem Licht, insbesondere Licht einer Wellenlänge λ von ≤ 250 nm, vollflächig belichtet werden.

Ein weiterer Vorteil des erfindungsgemäßen Verfahrens ist es, daß es mit Hilfe zahlreicher bekannter lichtempfindlicher Aufzeichnungselemente mit photopolymerisierbarer Aufzeichnungsschicht mit gutem Erfolg ausgeführt werden kann. Solche bekannten lichtempfindlichen Aufzeichnungselemente umfassen üblicherweise einen dimensionsstabilen Träger und mindestens eine photopolymerisierbare lichtempfindliche Aufzeichnungsschicht, die mindestens ein Polymer als Bindemittel, mindestens ein photopolymerisierbares Monomeres, welches mit dem monomeren Bindemittel verträglich ist, und mindestens einen Photopolymerisationsinitiator enthält. Diese lichtempfindlichen Aufzeichnungselemente werden von der Fachwelt auch etwas ungenau als "Hochdruckplatten" oder, sofern ein elastomeres Polymer als Bindemittel verwendet wird, als "Flexodruckplatten" bezeichnet.

Die photopolymerisierbaren Aufzeichnungsschichten dieser Hochdruck- oder Flexodruckplatten können außer den vorstehend genannten essentiellen Komponenten noch geeignete Zusatzstoffe wie Inhibitoren der thermisch initiierten Polymerisation, Farbstoffe, Pigmente, photochrome Stoffe, Lichthofschutzmittel, Weichmacher, Antioxidantien, Antiozonantien, Mittel zur Verbesserung der Reliefstruktur, Vernetzungshilfsmittel, Flußmittel, Trennmittel, Füllmittel und/oder Verstärkerfüllstoffe in wirksamen Mengen enthalten. Hierbei können die Hochdruck- oder Flexodruckplatten mehrere dieser photopolymerisierbaren Aufzeichnungsschichten übereinanderliegend und haftfest miteinander verbunden enthalten, wobei diese einzelnen Schichten von stofflich gleicher, in etwa gleicher oder unterschiedlicher Zusammensetzung sein können.

Beispiele geeigneter lichtempfindlicher Aufzeichnungselemente, mit deren Hilfe das erfindungsgemäße Verfahren in vorteilhafter Weise durchgeführt werden kann, sind aus den Patentschriften EP-B-0 084 851, US-A-4 323 636, US-A-4 369 246, US-A-4 323 636, EP-B-0 133 265, US-A-4 162 919, US-A-4 320 188 (DE-A-29 42 183), EP-B-0 027 612, DE-A-29 39 989, DE-C-22 15 090, EP-A-0 293 750, EP-A-0 231 002, EP-A-0 226 153, EP-A-0 223 114 und EP-A-0 326 977 bekannt.

Nicht zuletzt erweist es sich als ganz besonders bedeutsamer Vorteil des erfindungsgemäßen Verfahrens, daß bei dem Ausfüllen des Schleifreliefs mit einem thermoplastischen Bindemittel in erfindungsgemäßer Verfahrensweise photopolymerisierbare Aufzeichnungsschichten und thermoplastische Bindemittel völlig unterschiedlicher Löslichkeitseigenschaften miteinander kombiniert werden können, ohne daß hiernach bei der Entwicklung der bildmäßig belichteten Aufzeichnungsschichten ein zusätzlicher Entwicklungs- oder "perwipe"-Schritt notwendig wird. Ganz im Gegenteil können die nahtlos aufgebrachten bildmäßig belichteten Aufzeichnungsschichten mit Hilfe des erfindungsgemäßen Verfahrens in einem Arbeitsgang entwickelt werden.

Die nach dem erfindungsgemäßen Verfahren hergestellten Druckzylinder mit nahtloser photopolymerer Reliefschicht eignen sich ganz hervorragend für den endlosen Rotationsdruck. Hierbei erweisen sie sich als ausgesprochen stabil gegenüber den Lösungsmitteln der üblicherweise verwendeten Hochdruck- oder Flexodruckfarben und liefern exzellente Druckerzeugnisse in besonders hoher Auflage. Nach ihrem Gebrauch können sie längere Zeit gelagert und danach wieder verwendet werden, ohne daß eine Veränderung des Druckbildes zu befürchten wären. Somit wären dann mit Hilfe des erfindungsgemäßen Verfahrens nicht nur die Qualitätsverluste, welche bekanntermaßen durch den Schleifprozeß verursacht werden, wieder behoben, sondern es werden darüber hinaus auch noch weitere besondere Vorteile erzielt.

Beispiele und Vergleichsversuche

Die Flexodruckplatten, welche für die Beispiele und Vergleichsversuche verwendet wurden, wiesen allesamt eine 125 μm starke, mit einem Polyurethanhaftlack beschichtete Polyethylenterephthalatfolie als dimensionsstabilen Träger auf. Ihre photopolymerisierbaren reliefbildenden Aufzeichnungsschichten waren 2700 μm dick und bestanden aus

| | |
|---|---|
| 87,952 Gew.-% | des Styrol/Isopren/(Styrol-Butadien)-Dreiblockmischpolymerisats gemäß der EP-A-0 027 612, |
| 5 Gew.-% | eines Paraffinöls, |
| 5 Gew.-% | Hexan-1,6-diol-diacrylat, |
| 1,2 Gew.-% | Benzildimethylacetal, |
| 1,2 Gew.-% | 1,2,6-Di-tert.-butyl-p-kresol und |
| 0,008 Gew.-% | des Farbstoffs Solvent Black (C.I. 26 150). |

Diese Flexodruckplatten wurden, wie in der DE-A-27 22 896 beschrieben, nahtlos auf je einen Druckzylinder montiert.

Beispiele 1 bis 3

Herstellung von Druckzylindern mit nahtloser photopolymerer Reliefschicht für den Rotationsdruck nach dem erfindungsgemäßen Verfahren

Versuchsvorschrift:

Für die Durchführung der Beispiele 1 bis 3 wurden 3 der vorstehend beschriebenen nahtlos beschichteten Druckzylinder zur Erzielung der erforderlichen Rundlaufgenauigkeit auf eine Dickentoleranz von ± 10 $\mu$m geschliffen.

Hiernach wurde das Schleifrelief des Druckzylinders des Beispiels 1 unter gleichmäßigem langsamem Drehen (10 UpM) in die Wasser-in-Öl-Emulsion der folgenden Zusammensetzung getaucht:

- 40 Vol.-% des entaromatisierten Testbenzins Exxsol® D 60 der Firma Esso (Siedebereich 186 bis 217˚C; Flammpunkt nach DIN 51 755 61˚C; geruchlos; Aromatengehalt ≤ 1 %; Gehalt an naphthenischen Kohlenwasserstoffen 35 %; Paraffingehalt ≥ 64 %)
- 10 Vol.-% n-Butanol und
- 50 Vol.-% Leitungswasser.

Zum Zwecke der Stabilisierung enthielt die Wasser-in-Öl-Emulsion einen nichtionischen Emulgator. Die Behandlungsdauer lag bei 30 Sekunden. Nach der Behandlung war die Oberfläche des Druckzylinders des Beispiels 1 einwandfrei geglättet, ohne daß es zu einer starken Quellung des Schleifreliefs gekommen wäre.

Im Anschluß daran wurde die Emulsion von der Druckzylinderoberfläche mit reinem Exxsol® D 60 abgespült. Hiernach wurde der Druckzylinder kurz getrocknet.

Hiernach wurde die Oberfläche der photopolymerisierbaren Aufzeichnungsschicht des Druckzylinders mit einer dünnen Trennschicht aus einem Polyamid (Macromelt® 6900 der Firma Henkel) in einer Dicke von 3 $\mu$m beschichtet. Zu diesem Zweck wurde eine 5 %ige Lösung des Polyamids in n-Butanol verwendet.

Der Druckzylinder des Beispiels 2 wurde wie der des Beispiels 1 geglättet, nur daß die Oberfläche nach dem Glätten mit einer wäßrigen Tensidlösung abgespült wurde und die photopolymerisierbare Aufzeichnungsschicht des Druckzylinders des Beispiels 2 mit einer 2 $\mu$m starken Trennschicht aus einem Propfcopolymer aus Ethylenoxid mit Polyvinylalkoholseitenketten (Mowiol® 04/M1 der Firma Hoechst) beschichtet wurde. Hierbei wurde das Pfropfcopolymer aus einer Lösung aus Propanol/Wasser im Volumenverhältnis von 8:2 aufgetragen.

Im Unterschied zu den Druckzylindern der Beispiele 1 und 2 erfolgte beim Druckzylinder des Beispiels 3 das Glätten und das Auftragen der Trennschicht bzw. das Ausfüllen des Schleifreliefs in einem Arbeitsgang. Hierzu wurde eine Wasser-in-Öl-Emulsion verwendet, welche aus 50 Vol.-% Exxsol® D 60 und 50 Vol.-% einer 3 gew.-%igen wäßrigen Lösung von Mowiol® 04/M1 bestand. Der Zusatz eines Emulgators zur Stabilisierung der Wasser-in-Öl-Emulsion war hierbei nicht notwendig. Nach dem Trocknen resultierte ein Druckzylinder, dessen nahtlose photopolymerisierbare Aufzeichnungsschicht geglättet und von einer 2 $\mu$m starken Trennschicht aus dem Pfropfcopolymer Mowiol® 04/M1 gleichmäßig bedeckt war.

Für die bildmäßige Belichtung mit aktinischem Licht wurde eine auf dem Flexodruckplattengebiet übliche und bekannte Negativ-Vorlage verwendet. Die Belichtung selbst erfolgte in einem Rundbelichter mit einer Belichtungszeit von 6 Minuten.

Im Anschluß daran wurden die bildmäßig belichteten Druckzylinder der Beispiele 1 bis 3 mit der Wasser-in-Öl-Emulsion des Beispiels 1 entwickelt und danach getrocknet.

Vor den Druckversuchen wurde die durchschnittliche Näpfchentiefe in den nahtlosen photopolymeren Reliefschichten der Druckzylinder der Beispiele 1 bis 3 in üblicher und bekannter Weise bestimmt. Hiernach wurden die Druckzylinder der Beispiele 1 bis 3 in eine Flexodruckmaschine eingesetzt und zum Drucken mit üblichen und bekannten Flexodruckfarben verwendet.

Die Tabelle 1 faßt noch einmal die wichtigsten Parameter des erfindungsgemäßen Verfahrens zusammen, und die Tabelle 2 gibt einen Überblick über die erhaltenen Versuchsergebnisse.

Vergleichsversuche V1 bis V4

Die Herstellung von Druckzylindern mit nahtloser photopolymerer Reliefschicht für den Rotationsdruck nach bekannten Verfahren

Versuchsvorschrift:

8

Bei dem Vergleichsversuch V1 wurde im wesentlichen wie bei dem Beispiel 1 verfahren, nur daß die geschliffene Oberfläche der photopolymerisierbaren Aufzeichnungsschicht nicht geglättet wurde.

Bei den Vergleichsversuchen V2 und V3 wurde auf das Schleifen verzichtet. Stattdessen wurde bei dem Druckzylinder des Vergleichsversuchs V2 in üblicher und bekannter Weise eine Trennschicht aus Mowiol® 04/M1 aufgebracht, und auf den Druckzylinder des Vergleichsversuchs V3 wurde eine Trennschicht aus Makromelt® 6900 aufgetragen. Bei dem Vergleichsversuch V4 wurde im wesentlichen wie bei dem Beispiel 1 verfahren, nur daß für das Glätten 1,1,1-Trichlorethan und für das Entwickeln eine Mischung aus Tetrachlorethylen und n-Butanol im Volumenverhältnis von 80:20 verwendet wurde.

Wie bei den Beispielen 1 bis 3 wurde bei den Vergleichsversuchen V1 bis V4 vor dem Drucken mit den Druckzylindern die durchschnittliche Näpfchentiefe in den nahtlosen photopolymeren Reliefschichten bestimmt. Außerdem wurde darauf geachtet, ob die Reliefschichten der Vergleichsversuche V1 bis V4 angequollen waren oder nicht. Hiernach wurde mit den Druckzylindern der Vergleichsversuch V1 und V4 wie bei den Beispielen 1 bis 3 beschrieben gedruckt.

Die Tabelle 1 faßt noch einmal die wichtigsten Verfahrensparameter zusammen, und die Tabelle 2 und gibt einen Überblick über die erhaltenen Versuchsergebnisse.

Der Vergleich der in der Tabelle 2 zusammengestellten Versuchsergebnisse der Beispiele 1 bis 3 mit denjenigen der Vergleichsversuche V1 bis V4 belegen die Überlegenheit des erfindungsgemäßen Verfahrens.

Tabelle 1:

Die Herstellung von Druckzylindern mit nahtloser photopolymerer Reliefschicht nach dem erfindungsgemäßen Verfahren (Beispiele 1 bis 3) und in üblicher und bekannter Weise (Vergleichsversuche V1 bis V4); Verfahrensparamter

| Bei-spiel | Verfahrensparameter: Schleifen | Glätten mit | Entwickeln mit | Trennschicht aus |
|---|---|---|---|---|
| 1 | ja | W/O-E1[a] | W/O-E1[a] | Polyamid[b] |
| 2 | ja | W/O-E1[a] | W/O-E1[a] | Pfropfcopolymer[c] |
| 3 | ja | W/O-E2[d] | W/O-E1[a] | Pfropfcopolymer[c] |
| Vergl. Vers. | | | | |
| V1 | ja | – | W/O-E1[a] | Polyamid[b] |
| V2 | – | – | W/O-E1[a] | Pfropfcopolymer[c] |
| V3 | – | – | W/O-E1[a] | Polyamid[b] |
| V4 | ja | 1,1,1-Trichlorethan | Per/Bu[e] | Polyamid[b] |

[a] Wasser-in-öl-Emulsion aus Exxsol® D 60 (40 Vol.-%), n-Butanol (10 Vol.-%) und Wasser (50 Vol.-%)

[b] Makromelt® 6900 der Firma Henkel

[c] Mowiol® 04/M1 der Firma Hoechst

[d] Wasser-in-öl-Emulsion aus Exxsol® D 60 (50 Vol.-%) und 3 %iger wäßriger Mowiol® 04/M1-Lösung

[e] Gemisch aus Perchlorethylen und n-Butanol im Volumenverhältnis 80:20

Tabelle 2: Versuchsergebnisse

| Bei-<br>spiel | Versuchsergebnisse:<br>durchschnittliche<br>Näpfchentiefe<br>$\mu$m | Quellung<br>der Relief-<br>schicht | Auflagen-<br>stärke | Druckbild und<br>Wiedergabe der<br>Negativvorlage |
|---|---|---|---|---|
| 1 | 50 | keine | >500.000 | exzellent,<br>völlig detailgetreu |
| 2 | 60 | keine | >500.000 | exzellent,<br>völlig detailgetreu |
| 3 | 57 | keine | >500.000 | exzellent,<br>völlig detailgetreu |
| Vergl. Vers. | | | | |
| V1 | 25 | keine | 50.000 | schlecht, sehr ungenau |
| V2 | 60 | keine | 100.000 | schlecht, ungenau |
| V3 | 52 | keine | 100.000 | schlecht, ungenau |
| V4 | 57 | ja | >500.000 | gut, nicht völlig<br>detailgetreu |

**Patentansprüche**

1. Verfahren zur Herstellung von Druckzylindern mit nahtloser photopolymerer Reliefschicht für den Rotationsdruck durch

   A) nahtloses Aufbringen eines lichtempfindlichen Aufzeichnungselements mit einer photopolymerisierbaren Aufzeichnungsschicht auf der Oberfläche eines Druckzylinders,

   B) Schleifen der Oberfläche der photopolymerisierbaren Aufzeichnungsschicht,

   C) Glätten der geschliffenen Oberfläche durch

   $C_1$) eine Behandlung der geschliffenen Oberfläche mit einem organischen Lösungsmittel oder Lösungsmittelgemisch, worin die photopolymerisierbare Aufzeichnungsschicht löslich oder dispergierbar ist, und/oder

   $C_2$) das Ausfüllen des Schleifreliefs mit einem thermoplastischen Bindemittel und/oder

   $C_3$) eine Wärme und/oder Druckbehandlung,

   D) bildmäßiges Belichten der photopolymerisierbaren Aufzeichnungsschicht mit aktinischem Licht und

   E) Auswaschen (Entwickeln) der unbelichteten und daher nicht photopolymerisierten Bereiche der bildmäßig belichteten Aufzeichnungsschicht mit einem geeigneten Lösungsmittel oder Lösungsmittelgemisch, wodurch die nahtlose photopolymere Reliefschicht resultiert,

   dadurch gekennzeichnet, daß man bei den Verfahrensschritten ($C_1$), ($C_2$) und/oder (E) eine Emulsion vom Typ "Wasser-in-Öl" verwendet, welche eine fein dispergierte wäßrige Phase und eine kontinuierliche nichtbrennbare oder schwerbrennbare und/oder hochsiedende organische Phase im Volumenverhältnis von 90:10 bis 10:90 enthält.

2. Verfahren nach Anspruch 1, dadurch gekennzeichnet, daß das Volumenverhältnis bei 60:40 bis 40:60 liegt.

3. Verfahren nach Anspruch 1 oder 2, dadurch gekennzeichnet, daß die organische Phase chlorierte Kohlenwasserstoffe, aromatische Kohlenwasserstoffe, Ester, Ether und/oder Ketone, gesättigte und/oder ungesättigte cyclische und/oder acyclische Kohlenwasserstoffe, Ester, Ether und/oder Ketone, Petroleumdestillate, hydrierte Erdölfraktionen und/oder deren Gemische enthält oder hieraus besteht.

4.  Verfahren nach einem der Ansprüche 1 bis 3, dadurch gekennzeichnet, daß die Wasser-in-Öl-Emulsion, bezogen auf ihre Gesamtmenge, 0,1 bis 30 Vol.-% mindestens eines Alkohols enthält.

5.  Verfahren nach einem der Ansprüche 1 bis 4, dadurch gekennzeichnet, daß die Wasser-in-Öl-Emulsion, bezogen auf ihre Gesamtmenge, 0,001 bis 20 Vol.-% mindestens einer oberflächenaktiven Verbindung enthält.